Europäisches Patentamt

European Patent Office

Office européen des brevets

(19)

(11) Publication number: **0 103 353**
**A2**

# (12) EUROPEAN PATENT APPLICATION

(21) Application number: **83303251.9**

(22) Date of filing: **06.06.83**

(51) Int. Cl.³: **G 01 R 31/28**

(30) Priority: **13.09.82 US 417215**

(43) Date of publication of application: **21.03.84**
**Bulletin 84/12**

(84) Designated Contracting States: **AT BE CH DE FR GB IT LI LU NL SE**

(71) Applicant: **GENRAD, INC., 300 Baker Avenue, Concord Massachusetts01742 (US)**

(72) Inventor: **Faran, James J., Jr., Tabor Hill Road, Lincoln Massachusetts (US)**
Inventor: **Fichtenbaum, Matthew L., 46 Sleigh Road, Chelmsford Massachusetts (US)**
Inventor: **Kabele, William C., 16 Deer Run Road, Littleton Massachusetts (US)**

(74) Representative: **Allsop, John Rowland et al, c/o Edward Evans & Co. Chancery House 53-64 Chancery Lane, London, WC2A 1SD (GB)**

(54) **Method of and apparatus for multiplexed automatic testing of electronic circuits and the like.**

(57) This disclosure is concerned with the automatic testing of electronic circuits and assemblies and the like containing large numbers of nodes, with reduced replications of test instruments and thus significantly reduced cost, through permitting a number of driver-sensors to be selectively switched to a larger number of nodes of the circuit being tested in accordance with a method of specifying and allocating the connections of the nodes of that circuit to the pins associated with each driver-sensor (or group thereof) that insures that no conflicts arise in connecting the driversensors to various groups of nodes for carrying out the desired tests.

- 1 -

METHOD OF AND APPARATUS FOR

MULTIPLEXED AUTOMATIC TESTING

OF ELECTRONIC CIRCUITS AND THE LIKE

The present invention relates to the automatic testing of electronic circuits or assemblies with the aid of test instruments, controlled by a computer or similar apparatus, that provide excitation or stimulus signals to nodes of the assembly under test, analog and digital, and measure responses; being more particularly directed to novel methods of and apparatus for such testing employing fewer or minimum numbers of replications of such instruments and with each such instrument switched to various connection points with limitation on the range of such connection points to which any instrument can be connected, the assignment of assembly nodes to the connection points being such as to avoid conflicts in use thereof.

Circuit testing apparatus presents an interface to the assembly under test consisting of a plurality of connection points. Since circuit assemblies may assume many different sizes and shapes, fixtures are employed which make contact with those connection points and provide whatever unique mechanism may be needed to contact the external nodes, or both external and internal nodes, of the assembly under test. Such contacts with nodes of the assembly under test are sometimes made by means of spring-loaded pins touching the metallic conductor of the nodes; the fixtures usually containing wiring connecting each spring pin or other contacting device to connection points which mate with those of the testing apparatus.

There are two broad classes of test systems currently used in the art, functional and in-circuit. Functional testing is conducted by connecting the tester only to the nodes of the assembly to be tested that are those used in its normal application. These nodes are called the external nodes. Signals applied during functional test of circuit resemble, more or less, the signals which would be present in its normal application. Functional testing therefore, is designed to determine whether all components of the assembly work successfully in concert with each other.

In in-circuit testing, each component of the assembly is tested individually, independent of the other components.  The test routine thus consists of a sequence of many independent routines, each of which controls the testing of one of the components.  Generally, the test instruments are connected to nodes of the assembly under test in a unique way for each such individual test routine. In the process, during the various tests of the individual components, instruments are connected to substantially all the nodes of the assembly under test, at one time or another.

In-circuit test apparatus thus requires the ability to make connection to more nodes of the assembly being tested than functional test apparatus; but, in general, at any one time, uses fewer test instruments.

-4-

The present invention is concerned with making such testing more economical by reducing the number of test instruments required, and is particularly applicable to in-circuit testing at the present time, though also useful in other types of testing, including functional, as, for example, in conjunction with a pre-wired "universal fixture" for testing a family of circuit boards, or in a system employing a dual fixture, where test instruments might be connected to one side while the assembly being · tested was being handled on the other side.

In this specification, phrases and terms and variants thereof are employed which are intended to have rather specific meanings; definitions accordingly being tabulated as follows:

Circuit Under Test - Any assembly of electrical-electronic components electrically connected to form a complete or partial electronic circuit which is to be tested by the testing apparatus herein described.

Pin - Broadly, the connection, sometimes including the electronic circuits associated therewith, to an electrical node of a circuit under test (named after the spring contact pins often used for the purpose).

0103353

Node (of a circuit under test) - One of the electrical interconnection points or terminals of the electronic circuit.

Testing Apparatus - A collection of apparatus, usually computer-controlled, for verifying that an electronic circuit assembly has been correctly assembled from the proper components.

Connection Point (of a testing apparatus) - One of the points of the testing apparatus where connections are made (usually by means of a fixture) to the circuit under test.

. Fixture - An assembly by means of which the connection points of a testing apparatus are connected to the nodes of a circuit under test (often containing spring contact pins in a "bed-of-nails" arrangement).

Analog Instrument - Any one of a number of types of electronic apparatus which are intended to make measurements of parameters of analog (non-digital) components of an electronic circuit. Such instruments may, for example, measure resistance, capacitance or inductance of components or may measure currents or voltages present in the circuit under test. Each such instrument may require from two to four or more connections to nodes of the circuit in order to operate.

Digital Instrument - Electronic apparatus which is capable of applying digital electronic signals to a circuit under test, or of sensing the logic state (high or low) of the signals generated by a circuit under test.

Driver-Sensor - A combination of two types of digital instruments which is capable of driving a digital signal to a node of the circuit assembly under test and/or of sensing the logic state of that node.

Digital Signal - An electrical signal which varies with time and which has a high probability of being at one of two voltage levels (high or low).

Analog Signal - An electrical signal which varies with time and which has a continuous range of possible voltage levels.

-7-

One type of prior art architecture used in such testing systems as the types 1792, 1796, and 2270 of GenRad, Inc., the assignee of the present invention, attaches analog instruments to the assembly to be tested by a switch array, with digital instruments being connected directly. For example, replicated pairs of drivers and sensors associated with digital instruments are used with the drivers exciting the assembly and the sensors testing its response. Digital pins and analog pins may be connected to the same assembly node to form hybrid pins capable of supporting digital or analog test signals.

Another basic type of architecture in which both analog and digital instruments are attached to the circuit assembly to be tested employs a switch array, with any pin electrically connectable to any test instrument. Products involving this type of structure have been made by Fairchild/Faultfinders, Inc., 15 Avis Dr., Latham, New York and Zehntel, Inc., 2625 Shetlands Dr.,

-8-

Walnut Creek, California. This type of architecture is illustrated in U. S. patent no. 4,070,565 of Zehntel. Other relevant patents of Instrumentation Engineering, Inc., Franklin Lakes, New Jersey, illustrating this type of architecture include U. S. patent nos. 3,832,535; 3,854,125; 3,922,537 and 4,102,491.

Still another testing architecture approach involves directly connecting digital drivers and attaching one digital sensor by a switch array to various points of the assembly to be tested. This type of configuration is described, for example, in U. S. patent no. 4,216,539 of Zehntel.

Prior art digital test instruments have thus been connected to the assembly to be tested in two basic ways. First, instruments are replicated to allow direct connection between each instrument and a node of the assembly to provide a number of digital instruments equal to or greater than the number of nodes of the assembly. Alternatively, a necessary few instruments are attached to the assembly by way of a switch array in the same manner as for analog instruments, above described. As with the analog case, the switch array contains a great number of switches to allow each node of the assembly to be electrically connected to any of the digital instruments present in the test system apparatus.

It has been found, in accordance with the present invention, that a significant reduction in required replications of test instruments used in the prior art and thus reduction in cost can be achieved through permitting a number of driver-sensors to be selectively switched to a larger number of nodes of the circuit being tested in accordance with a novel method of specifying the connections of the nodes of that circuit to the pins associated with each driver-sensor (or group thereof) that insures that no conflicts arise in connecting the driver-sensors to various groups of nodes for carrying out the desired tests.

More specifically, the invention provides an improved method of and apparatus for more efficient

0103353

-10-

structuring of the automatic test equipment used to test electronic circuits and similar assemblies. The invention requires that

    a) connection points between the automatic test equipment and the circuit be partitioned into groups;

    b) each group be connected to test equipment, or a subset of the test equipment, of the automatic test equipment by a switching means; and

    c) the connection points be assigned (connected) to the circuit nodes in such a way that conflicts in test instrument application do not arise.

In general, the switching means allows each connection point to be connected to instrument types suitable for conduct of the test, but it does not allow any connection point to be connected to any test instrument at any time, as in the prior art.

Broadly, thus, the invention employs a medium number of digital instruments, each connectable

-11-

to any one (or more) of a group of the nodes of the assembly by means of a switch array, such that all assembly nodes may be electrically connected to a test instrument. While there are a number of (usually identical) switch arrays for digital test equal to the number of groups of the nodes of the assembly, the invention employs a modest number of instruments and very many fewer switches than in the prior art, resulting in significant economy.

It should be noted, as before stated, that the architecture of the invention does not allow any node of the assembly under test to be electrically connected to any of the digital instruments, as with the prior art. Each node can be connected to a digital instrument, but not to any digital instrument.

A further economy of the invention resides in attaching analog instruments via a switch array to the common points between digital instruments and the digital switch arrays. Thus, the analog connecting array is significantly smaller than is required in the prior art.

-12-

Prior to the invention, however, it was not apparent that the above architecture could really achieve, in practice, the desired results. Since there are fewer digital instruments than there are nodes of the assembly under test in accordance with the invention, cases can arise where more digital instruments are required to be active at nodes of a group than there are digital instruments associated with (and connectable to) that group. Such a conflict, when it occurs, actually precludes testing. It has been discovered, however, that such conflicts can be avoided by application of a method of assigning nodes of the assembly under test to connection points of the test apparatus which operates to prevent conflicts. Such assignment is implemented in the fixture which adapts from the connection points of the test apparatus to means (often a so-called bed-of-nails) for making contact with all nodes of the circuit assembly under test.

-13-

An object of the present invention, accordingly, is to provide a new and improved, more efficient and less costly method of and apparatus for automatic testing of electronic circuits and assemblies and the like, that unlike the above-described and similar prior art systems, employ a significantly reduced number of digital test instruments without impairing the capability of the test apparatus and while reducing the number of switches required to make full use of analog test instruments.

A further object is to provide a novel method of and apparatus for digital and/or analog multiplexed automatic testing of electronic circuits and the like.

Other and further objects will be explained hereinafter and are more particularly delineated in the appended claims.

In summary, however, from one of its important aspects, the invention embraces a method of multiplexed automatic testing by test equipment of electronic circuits and the like comprising a relatively large number of nodes, that comprises, partitioning the relatively large number of nodes into a relatively small number of groups of nodes; assigning each group of nodes to predetermined connection points connectable with predetermined test equipment; selectively switching the connection points to connect the corresponding test equipment to the corresponding nodes for conducting desired testing; and controlling said assigning of the nodes to specific connection points in a manner that insures that no more nodes, used simultaneously in any test, are assigned to the same group of connection points than there are test equipments connectable to those connection points. Preferred apparatus and techniques and best mode embodiments are hereinafter presented.

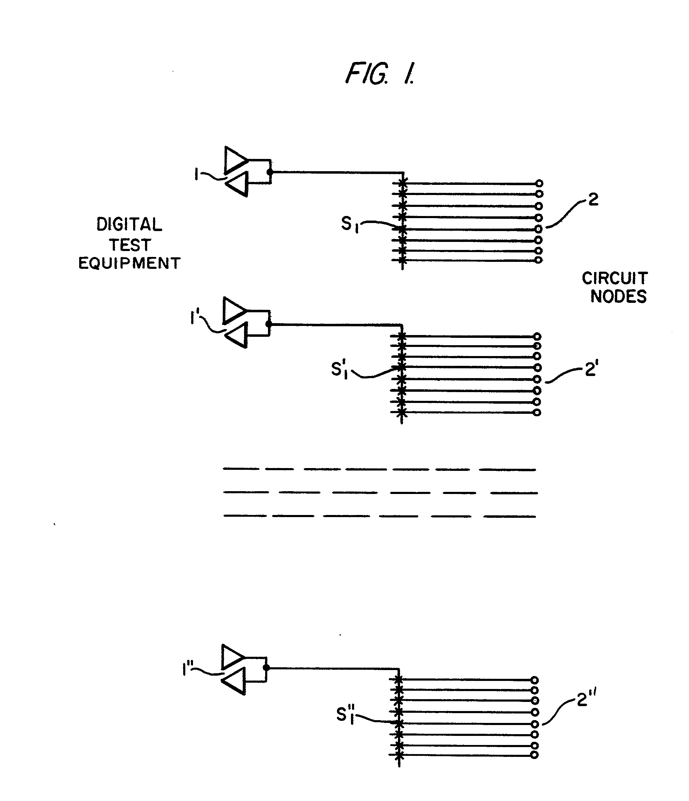

The invention will now be described in connection with the accompanying drawings, Fig. 1 of which is a schematic circuit diagram illustrating a simple, though exemplary, application of the invention to digital testing;

-15-

Figs. 2 and 4 are similar diagrams of preferred embodiments;

Figs. 3 and 5 are further modifications adapted for both digital and analog testing; and

Fig. 6 illustrates the method of the invention applied to analog testing alone.

Referring to the simple example of the invention illustrated in Fig. 1, each driver-sensor circuit 1, 1'...1" is shown connectable in multiplex fashion to eight connection points 2, 2'...2". Thus, for a system with 3840 connection points, only 480 driver-sensors are needed (and 3840 switches). In recognition of the fact that in in-circuit testing of the components of a digital circuit many fewer driver-sensors are used at any one time than there are connection points to the unit under test, the invention thus embodies significantly fewer driver-sensor circuits than connection points, and employs switches $S_1$, $S_1$...$S_1$" (cross-point switches diagramatically illustrated by crosses) to allow each driver-sensor circuit 1, 1'...1" to be connected to a number of connection points in the groups 2, 2'...2", with the test equipment associated with the driver sensors and the selected circuit nodes being generally referenced to the left and right, respectively. No two connection points in any group of eight (2, 2'...2") can be connected to nodes of the circuit assembly corresponding to different terminals of a component during the test of that component because there is only one driver-sensor behind that group. For this reason, it is necessary to assign nodes of the unit under test to connection points in such a way as to insure that the above condition is met. This can be done, once the test program has been written or generated, by assigning connection points so that no more than one connection point used in any individual component test is assigned within an eight-connection point group. This assignment can easily be carried out with the aid of a digital computer.

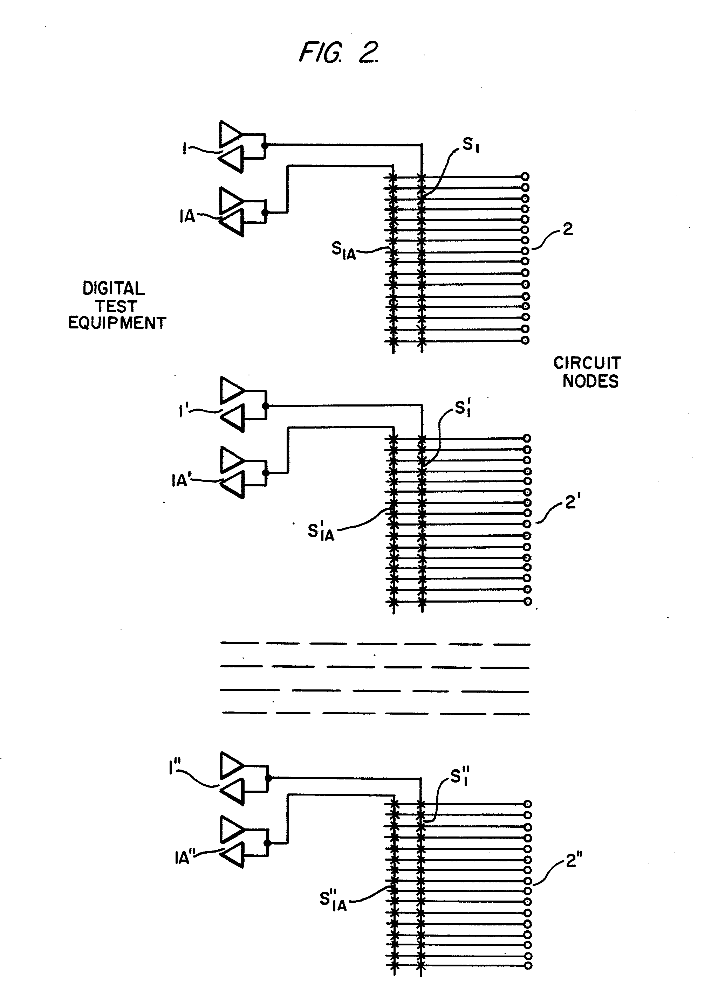

In a preferred embodiment of this invention, shown in Fig. 2, there is a set of two driver-sensors 1-1A, 1'-1A'...1"-1A" behind each group of

(sixteen) connection points 2, 2'...2",

and switches $S_1$-$S_{1A}$, $S_1'$-$S_{1A}'$...$S_1''$-$S_{1A}''$ arranged

so that each driver-sensor can be connected to any of the corresponding sixteen connection points.

This multiplexing arrangement is done for two reasons; so that resistance measurements (for shorts tests, for example) can be made between any two connection points, and so that two different connections can be made to any one connection point, as is done to improve the accuracy of linear or analog (as opposed to digital) measurements.

In this case, it is necessary to assign nodes of the assembly under test to connection points in such a way that no more than two nodes used in any test of one component are assigned within a group of sixteen connection points. Again, once the test program has been generated, this assignment can be carried out easily with a digital

computer.

-18-

In the case of a tester for purely digital circuit assemblies, economy is achieved by

a) providing fewer driver-sensors than one for each connection point, and

b) providing fewer switches than would allow any driver-sensor to be connected to any connection point.

In this digital case, if there are $N$ connection points and $M$ driver-sensors, the arrangement may permit each driver-sensor to be connected to any one or more of a group $n$ of the connection points, thus requiring $N$ switches. In a preferred embodiment, the arrangement may permit any of $m$ driver-sensors to be connected to any one or more of a group of $n$ of the connection points; in this case, requiring $m \times N$ switches. In either of these arrangements, the number of switches required can be far fewer than the $M \times N$ switches that would be required if each of the $M$ driver-sensors were connectable to any of the $N$ connection points.

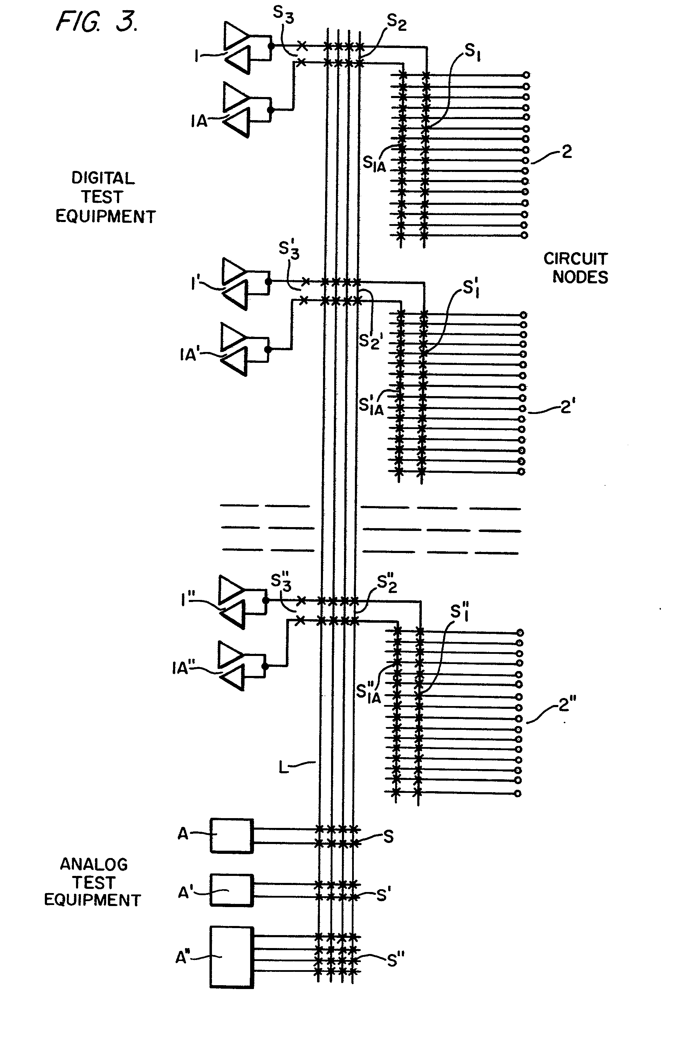

When the test system is capable of making both analog and digital tests, means must be provided for connection of the analog instruments to the connection points. Fig. 3 shows how that can be done according to this invention. It is the same arrangement as Fig. 2, with the addition of, in this case, four lines L for connection of the analog instruments A, A', A" to the connection points. Switches S, S'···S" allow the analog instruments to be connected to the analog lines L. Switches $S_2$, $S_2'$...$S_2$" allow those analog lines to be connected to any of the 480 dirver-sensor lines. Also included are one switch per driver-sensor $S_3$, $S_3'$...$S_3$" to allow it to be disconnected during analog measurement.

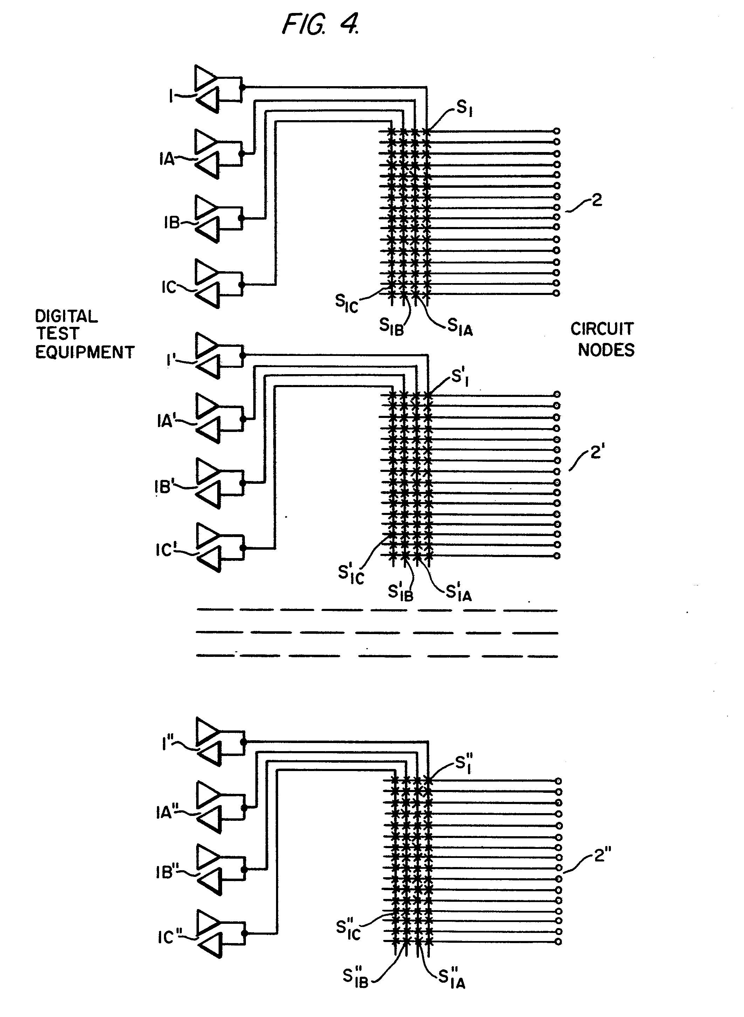

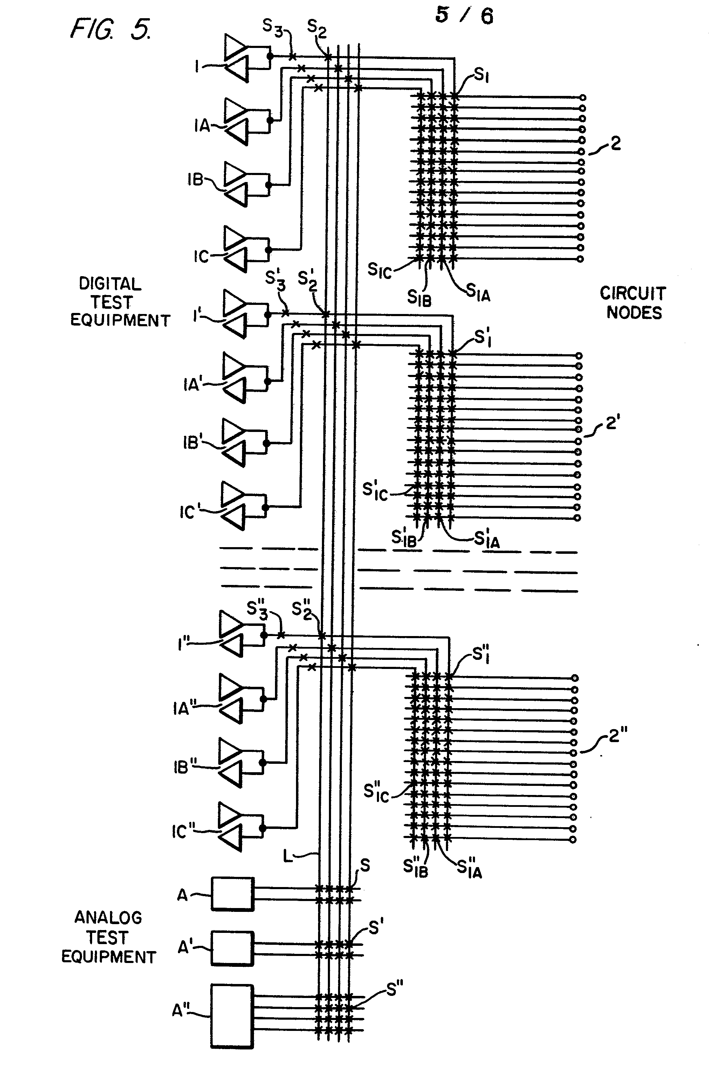

Another preferred embodiment of the invention is shown in Fig. 4 wherein a set of four driver-sensors 1-1A-1B-1C, 1'-1A'-1B'-1C'... 1"-1A"-1B"-1C" are provided behind each group of sixteen connection points 2, 2'...2". Analog instruments A, A', A" can also be connected in such a system by adding switches as in Fig. 5 so that each of the analog lines L can be connected to one of the digital lines of each group. This format is

-20-

advantageous when four analog lines are also used, since each can be connected by means of a switch to one of the driver-sensor lines. A switch to disconnect the driver-sensor circuit during analog measurements is also provided as at $S_3$, $S_3'$...$S_3''$. In the case of Figs. 4 and 5, it is necessary to assign nodes of the unit under test to connection points in such a way that no more than four connection points in any group are used simultaneously in the test of any component. This assignment can also be carried out in a straightforward manner using a digital computer, as before mentioned.

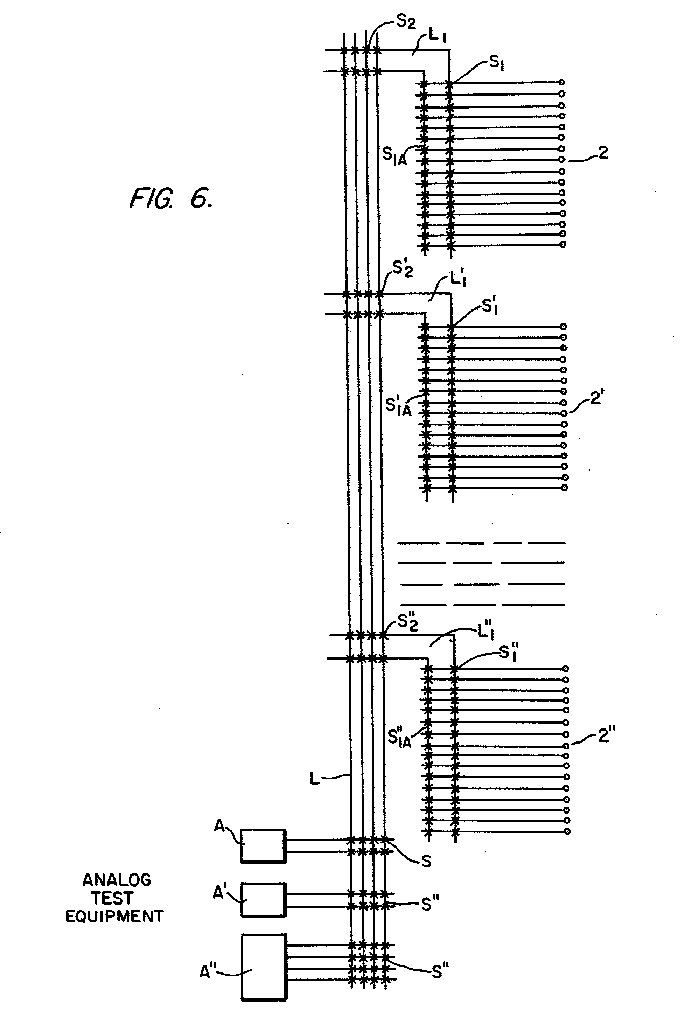

The same principles of the invention, furthermore, can be used in a system which does only testing of analog components (a system in which there are no driver-sensors). Such a system is illustrated in Fig. 6, as a sub-combination of the total system of Fig. 3. Sets of intermediate lines $L_1$, $L_1'$...$L_1''$ (normally from the driver sensors in the digital test equipment format) with cross-connection switches $S_2$, $S_2'$...$S_2''$ effect connection of the analog lines L selectively to desired connection points of the groups of connection points. For example, with k analog instrument lines switchable to permit each of the k lines to be connected to any one or more of M lines, with the remainder of the switches connected so as to permit each of a group of m of those M lines to be connected to any one or more of a corresponding group n of the N connection points, a total of $m \times N + M \times K$ switches would be required. This can be far fewer than the number $(K \times N)$ that would be required if each of the k analog lines were connectable to any of the N connection points, as in the prior art previously discussed.

The object of the method of assigning nodes of the circuit assembly under test to specific connection points of the test apparatus is to insure

-22-

that no more nodes, used simultaneously in any sub-test, are assigned into the same group of connection points than there are instruments connectable to those connection points. For a system architecture as previously described in connection with the embodiment of Fig. 2, this limit is one per group. For a system as shown in Fig. 3, the limit is two per group. For a system as shown in Fig. 5, the limit is four per group. When, as in in-circuit tests of all the individual components of an assembly, many different combinations of connections are used, the limit must not be exceeded in any of those sets of connections.

A most useful approach for assigning nodes to pins, and useful algorithm concepts for the previously discussed digital computer assignment control to achieve the efficiency and insure lack of instrument conflict, will now be addressed.

0103353

-23-

The test program is created before nodes can be assigned to connection points. When the limit is one node per group (Fig. 2) of connection points, a two-dimensional array is set up having as indices the numbers of the nodes of the circuit assembly. By reading each segment of the test program, and finding every node-pair involved in that segment of the test procedure, each such node pair can be marked in the array. Then, when a trial is made of assigning a second or subsequent node into a group of connection points, the elements of the array having the indices of the node being assigned and those of nodes already assigned within the group are checked to insure that the new node does not interfere in any test segment with any already assigned.

It had been initial concern during the evolution of the invention that in assigning nodes to pins, one would encounter problems of efficiency; i.e., that many more pins than the number of nodes in the circuit on the board might be required or that many more driver-sensors than the maximum number used simultaneously in one test might be needed. The method invented, however, produced highly efficient allocations.

The following TABLE I presents the results of the application of this technique in a system which multiplexes on a 1 by n basis, including the number of nodes on seven different circuit boards, the maximum number of nodes used simultaneously, the number of pin groups used, etc., and the efficiency of the resulting allocation. The efficiency is measured either as the number of pin groups needed to have one pin for each node or the number of pin groups needed to have enough driver-sensors for simultaneous use. divided by the number of pin groups actually used.

When the limit is two nodes per group (Fig. 3), a three-dimensional array must be used, in which triples of nodes involved in the same segment are marked. When the limit is four nodes per group (Fig. 5), a five-dimensional array is needed, in which quintuples of nodes involved in the same test segment are marked. In these cases, a similar procedure is followed to ensure that the limit is not exceeded.

To set up the before-described three-dimensional array for a 3000-node board would require

TABLE I　　　　　　0103353

EFFICIENCY OF ASSIGNMENT OF NODES TO PINS
FOR A SYSTEM WHICH MULTIPLEXES ON A 1 X N BASIS
FOR SEVEN DIFFERENT CIRCUIT BOARDS

| NODES ON BOARD | MAXIMUM NODES IN ONE BURST | ASSIGNED IN GROUPS OF | NUMBER OF GROUPS NEEDED FOR TOTAL NODES | FOR MAX NODES PER BURST | NUMBER OF GROUPS USED | EFFI-CIENCY | RATIO OF TOTAL NODES TO MAX NODES PER BURST |
|---|---|---|---|---|---|---|---|
| 175 | 47 | 1 X 4 | 44 | 47 | 59 | 0.80 | 3.7 |
| | | 1 X 6 | 30 | | 50 | 0.94 | |
| | | 1 X 8 | 22 | | 49 | 0.96 | |
| | | 1 X 16 | 11 | | 49 | 0.96 | |
| | | 1 X 32 | 6 | | 49 | 0.96 | |
| 198 | 44 | 1 X 4 | 50 | 44 | 57 | 0.88 | 4.5 |
| | | 1 X 6 | 33 | | 48 | 0.92 | |
| | | 1 X 8 | 25 | | 47 | 0.94 | |
| | | 1 X 16 | 13 | | 45 | 0.98 | |
| | | 1 X 32 | 7 | | 44 | 1.00 | |
| 222 | 54 | 1 X 4 | 56 | 54 | 64 | 0.87 | 4.1 |
| | | 1 X 6 | 37 | | 54 | 1.00 | |
| | | 1 X 8 | 28 | | 54 | 1.00 | |
| | | 1 X 16 | 14 | | 54 | 1.00 | |
| | | 1 X 32 | 7 | | 54 | 1.00 | |
| 265 | 24 | 1 X 4 | 67 | 24 | 70 | 0.96 | 11.0 |
| | | 1 X 6 | 45 | | 50 | 0.90 | |
| | | 1 X 8 | 34 | | 39 | 0.87 | |
| | | 1 X 16 | 17 | | 28 | 0.86 | |
| | | 1 X 32 | 9 | | 25 | 0.96 | |
| 685 | 60 | 1 X 4 | 172 | 60 | 172 | 1.00 | 11.4 |
| | | 1 X 6 | 115 | | 116 | 0.99 | |
| | | 1 X 8 | 86 | | 89 | 0.97 | |
| | | 1 X 16 | 43 | | 63 | 0.95 | |
| | | 1 X 32 | 22 | | 61 | 0.98 | |
| 695 | 54 | 1 X 4 | 174 | 54 | 175 | 0.99 | 12.9 |
| | | 1 X 6 | 116 | | 118 | 0.98 | |
| | | 1 X 8 | 87 | | 89 | 0.98 | |
| | | 1 X 16 | 44 | | 61 | 0.89 | |
| | | 1 X 32 | 22 | | 58 | 0.93 | |
| 1574 | 59 | 1 X 4 | 394 | 59 | 396 | 0.99 | 26.7 |
| | | 1 X 6 | 263 | | 268 | 0.98 | |
| | | 1 X 8 | 197 | | 211 | 0.93 | |
| | | 1 X 16 | 99 | | 134 | 0.74 | |
| | | 1 X 32 | 50 | | 100 | 0.59 | |

a virtual memory of 3400 Megabytes, and to set up a five-dimensional array for the same number of nodes would require 30 kilo-Mega-Megabytes. Although the size of such arrays, especially those of 3 or more dimensions, makes them clearly impossible to use in a practical situation, the method of assignment has been explained in terms of such arrays, for clarity in understanding the process of accumulating, from all segments of a test routine, the information which is needed, during the assignment procedure, to avoid conflicts during the testing process.

An effective and practical technique for assigning nodes to connection points in 2 by $n$ or 4 by $n$ multiplexing schemes is to divide the groups of $n$ connection points into subgroups of $n/2$ or $n/4$ connection points, respectively. Then node allocation can be carried out on a 1 by $n/2$ or 1 by $n/4$ basis, and, finally, the subgroups recombined into full groups. This procedure avoids the use of the very large arrays of 3 or more dimensions, yet produces allocations of quite satisfactory efficiency. The results of carrying out this procedure for the same examples as shown in Table I are shown in Tables II and III, following.

Another technique for avoiding the use of the large arrays in the computational process is to recognize that these arrays, in practice, are very sparcely marked, and various techniques for dealing with sparce matrices are applicable to make the process practical with finite computational capability. For example, only the sets of indices of the marked locations may be stored in groups of 2, 3 or 5, as appropriate for the above examples. Then, before a node is assigned to a group, those lists can be searched to ensure that no conflict will arise during any part of the test. Such procedure has also produced assignments which are highly efficient, and without requiring an inordinate amount of computer processing.

TABLE II

EFFICIENCY OF ASSIGNMENT OF NODES TO PINS FOR A SYSTEM WHICH IS MULTIPLEXED ON A BASIS OF 4 X 16 BY DIVISION INTO SUB-GROUPS AND ASSIGNING ON A 1 X 4 BASIS

| NODES ON BOARD | MAXIMUM NODES IN ONE BURST | ASSIGNED IN SUB-GROUPS OF | NUMBER OF 4 X 16 GROUPS NEEDED FOR TOTAL NODES | FOR MAX NODES PER BURST | NUMBER OF SUB-GROUPS USED | NUMBER OF 4 X 16 GROUPS USED | EFFI-CIENCY |
|---|---|---|---|---|---|---|---|
| 175 | 47 | 1 X 4 | 11 | 12 | 59 | 15 | 0.80 |
| 193 | 44 | 1 X 4 | 13 | 11 | 57 | 15 | 0.87 |
| 222 | 54 | 1 X 4 | 14 | 14 | 64 | 16 | 0.87 |
| 265 | 24 | 1 X 4 | 17 | 6 | 70 | 18 | 0.94 |
| 685 | 60 | 1 X 4 | 43 | 15 | 172 | 43 | 1.00 |
| 695 | 54 | 1 X 4 | 44 | 14 | 175 | 44 | 1.00 |
| 1574 | 59 | 1 X 4 | 99 | 15 | 396 | 99 | 1.00 |

TABLE III

EFFICIENCY OF ASSIGNMENT OF NODES TO PINS FOR A SYSTEM WHICH IS MULTIPLEXED ON A BASIS OF 2 X 16 BY DIVISION INTO SUB-GROUPS AND ASSIGNING ON A 1 X 8 BASIS

| NODES ON BOARD | MAXIMUM NODES IN ONE BURST | ASSIGNED IN SUB-GROUPS OF | NUMBER OF 2 X 16 GROUPS NEEDED FOR TOTAL NODES | FOR MAX NODES PER BURST | NUMBER OF SUB-GROUPS USED | NUMBER OF 2 X 16 GROUPS USED | EFFI-CIENCY |
|---|---|---|---|---|---|---|---|
| 175 | 47 | 1 X 8 | 11 | 24 | 49 | 25 | 0.96 |
| 193 | 44 | 1 X 8 | 13 | 22 | 47 | 24 | 0.92 |
| 222 | 54 | 1 X 8 | 14 | 14 | 54 | 27 | 1.00 |
| 265 | 24 | 1 X 8 | 17 | 12 | 39 | 20 | 0.85 |
| 685 | 60 | 1 X 8 | 43 | 30 | 89 | 45 | 0.96 |
| 695 | 54 | 1 X 8 | 44 | 27 | 89 | 45 | 0.93 |
| 1574 | 59 | 1 X 8 | 99 | 30 | 211 | 99 | 0.93 |

0103353

-29-

Preferred details as to types of driver-sensors, digital and analog test equipment, computer programs for automatic control, etc. are now well known in the art and may be employed with the technique of the present invention, reference being made to the previously cited prior patents and equipments for examples of the same. Modifications will occur to those skilled in the art and such are considered to fall within the spirit and scope of the invention as defined in the appended claims.

-30-

CLAIMS

1. A method of multiplexed automatic testing by test equipment of electronic circuits and the like comprising a relatively large number of nodes, that comprises, partitioning the relatively large number of nodes into a relatively small number of groups of nodes; assigning each group of nodes to predetermined connection points connectable with predetermined test equipment; selectively switching the connection points to connect the corresponding test equipment to the corresponding nodes for conducting desired testing; and controlling said assigning of the nodes to specific connection points in a manner that insures that no more nodes, used simultaneously in any test, are assigned to the same group of connection points than there are test equipments connectable to those connection points.

2. A method of improving the efficiency of the use of automatic test equipment for the testing of electronic circuits, having a large number of nodes, that comprises, partitioning connection points between the automatic test equipment and of circuit nodes into groups; switch-connecting each group to predetermined test equipment or a subset thereof; and assigning and allocating the connection of the connection points to the circuit nodes to insure that conflicts in test equipment application do not arise.

3. A method as claimed in claim 1 and in which said test equipment comprises digital test equipment provided with pin-connectable driver-sensors, and in which said assigning of nodes to predetermined connection points determines a corresponding group of pins connectable by said switching to said driver sensors, with the assigning of nodes to pins being effected to avoid conflict arising if the number of driver-sensors available to a group were not sufficient to serve all pins of that group that are simultaneously active during testing.

4. A method as claimed in claim 1 and in which said test equipment comprises analog test equipment having a limited number of analog lines, and in which said switching is effected from said limited number of lines connected to the analog test equipment, to said connection points; and said assigning and switching is effected to insure that no more connection points than the said limited number of lines in any group are used simultaneously for analog testing.

5. A method as claimed in claim 3 and in which said test equipment also includes analog test equipment having a limited number of analog lines, and in which said switching further is effected from said limited number of lines to

-33-

the said connection points; and said assigning is also effected to insure that no more connection points than the said limited number of lines in any group are used simultaneously for analog testing.

6. A method as claimed in claim 5 and in which further switching is effected at the driver sensors for enabling the said switching to connection points to occur selectively from the digital and analog test equipment.

7. A method of reducing the number of replications of digital test instruments required for the automatic testing, through pin-connectable driver-sensors, of electronic circuits comprising a large number of nodes, the method comprising dividing the large number of nodes into a relatively small number of groups of nodes; selectively switching a number of driver-sensors small compared to the said number of nodes of the circuit under test; specifying the connections of such nodes to the pins associated with each driver sensor or group thereof; and insuring that no conflict arises in connecting the driver-sensors to various groups of nodes for carrying out the desired tests.

8. A method of reducing the number of switches for analog test instruments required for the automatic testing of electronic circuits comprising a large number of nodes, from the number that would be required if each analog line were connectable to any circuit node, the method comprising dividing the large number of nodes into a relatively small number of groups of nodes and associating the same with a group of connection points; selectively switching connections from a limited number of lines connected to the analog instruments to said connection points; and insuring that no more connection points than the said limited number of analog instrument lines in any group are used simultaneously for testing.

9. A method as claimed in claim 3 and in which said controlling step is effected by digital computation that assigns nodes (n) to pins in at least one of 2 by n and 4 by n multiplexing, combining pin groups such that substantially all driver-sensors and pins are used insofar as possible in each group.

10. A method as claimed in claim 3 and in which the number of connection points in each group is eight or a multiple of eight and said assigning enables driver-sensors to be connected to any of their corresponding eight or multiple-of-eight connection points.

11. A method as claimed in claim 5 and in which the number of connection points in each group is eight or a multiple of eight.

12. A method as claimed in claim 11 and in which the number of connection points in each group is at least sixteen and the number of analog connection lines is at least four.

13. Apparatus for the multiplexed automatic testing by digital test equipment of electronic circuits and the like comprising a relatively large number of nodes, having, in combination, a plurality of groups of connection points, each group corresponding to a relatively small number of nodes; a corresponding plurality of sets of driver-sensor means associated with predetermined digital test equipment, the number of driver-sensors in each set being much smaller than the number of connection points in each said group; a corresponding plurality of sets of cross-connection switching means each set disposed between each driver-sensor of a driver-sensor set and each of the connection points of the corresponding group of connection points; and means for selectively controlling the operation of said switching means to connect predetermined digital test equipment through the corresponding driver-sensor means to connection

0103353

-37-

points of the corresponding group of connection points and thus to the corresponding nodes of the electronic circuit to effect desired testing, said means insuring that no more nodes used simultaneously in any test are assigned to the same group of connection points than there are predetermined test equipments connectable to those connection points.

14. Apparatus as claimed in claim 13 and in which said last-named means comprises digital compensation means programmed to assign nodes (n) to connection points in at least one of 2 by n and 4 by n multiplexing, combining groups of connection points such that substantially all driver-sensor means and connection points are used insofar as possible in each group.

15. Apparatus as claimed in claim 13 and in which the number of connection points in each group is eight or a multiple thereof, and said last-named means enables each driver-sensor to be connected to any of the connection points of its corresponding group of connection points.

16. Apparatus as claimed in claim 15 and in which each group of driver-sensor means comprises one or more pairs of driver-sensors.

17. Apparatus as claimed in claim 13 and in which facility for testing by analog test equipment having a limited number of analog lines less than said number of connection points is also provided by means for connecting said analog lines to each of said plurality of cross-connection switching means, with further switching means provided to disconnect said analog lines therefrom and to connect the driver-sensor means thereto.

18. Apparatus as claimed in claim 17 and in which said insuring means comprises means for enabling no more connection points of any group thereof than the said limited number of analog lines to be used simultaneously for analog testing.

19. Apparatus for the multiplexed automatic testing by analog test equipment, having a limited number of analog lines, of electronic circuits and the like comprising a relatively large number of nodes, said apparatus having, in combination, a plurality of groups of connection points, each group corresponding to a relatively small number of nodes; a corresponding plurality of sets of intermediate connection lines connectable to the said analog lines; a corresponding plurality of sets of cross-connection switching means each set disposed between the intermediate connection lines and each of the connection points of the corresponding group of connection points;

0103353

-40-

and means for selectively controlling the operation of the switching means for insuring that no more connection points of any group thereof than the said limited number of analog lines be used simultaneously for analog testing.

20. Apparatus as claimed in claim 19 and in which further cross-connection selection switching means is provided between each of the analog test equipments and the analog lines.

21. Apparatus as claimed in claim 19 and in which further cross-connection selection switching means is provided between said analog lines and said sets of intermediate lines.

22. In a system for testing the individual components of an assembled digital electronic circuit, the combination of M driver-sensors, N connection points to the circuit under test divided into groups of $n$ each, N switches connected between the driver-sensors and connection points,

-41-

and means for controlling the switches to permit each driver-sensor to be connected to any one or more of its associated group of $n$ connection points.

23. In a system for testing the individual components of an assembled digital electronic circuit, the combination of $N$ driver-sensors divided into groups of m each, $N$ connection points to the circuit under test divided into groups of n each, m x $N$ switches connected between the driver-sensors and connection points, and means for controlling the switches to permit each of every group of $m$ of the driver-sensors to be connected to any one or more of its associated group of $n$ connection points.

24. Apparatus as claimed in claim 23, and in which further switching means are provided to permit any of the analog instruments to be connected to one or more of $k$ lines, and to permit any k lines from the analog instruments to be substituted for or connected simultaneously with any of the driver-sensors.

0103353

-42-

25. Apparatus as claimed in claim 22 and in which further switching means are provided to permit any of the analog instruments to be connected to one or more of k lines, and to permit any of the k lines from the analog instruments to be substituted for or connected simultaneously with any of the driver-sensors.

26 In a system for testing the individual components of an assembled analog electronic circuit, the combination of analog instruments, switches and N connection points to the circuit under test, part of said switches being connected to connect the analog instruments to k lines, others of said switches being connected to permit each of said k lines to be connected to any one or more of M lines, and the remainder of said switches being connected to permit each of a group of m of those M lines to be connected to any one or more of an associated group of $n$ of said connection points.

FIG. 1.

FIG. 2.

DIGITAL
TEST
EQUIPMENT

I

IA

$S_1$

$S_{IA}$

2

CIRCUIT
NODES

I'

IA'

$S_1'$

$S_{IA}'$

2'

I"

IA"

$S_1''$

$S_{IA}''$

2"

FIG. 3.

0103353

3 / 6

DIGITAL TEST EQUIPMENT

CIRCUIT NODES

ANALOG TEST EQUIPMENT

FIG. 4.

DIGITAL
TEST
EQUIPMENT

CIRCUIT
NODES

FIG. 5.

0103353

5 / 6

FIG. 6.

0103353

6 / 6

ANALOG
TEST
EQUIPMENT